# EUROPEAN PATENT APPLICATION

(11) **EP 2 654 076 A2**
(43) Date of publication of application: **23.10.2013**
(21) Application number: 13163836.3
(22) Date of filing: 16.04.2013
(51) Int. Cl.: H01L 21/683, C09J 7/02

(54) **Method of dicing a substrate**

(30) Priority: 17.04.2012 JP 2012093856
(71) Applicant: NITTO DENKO CORPORATION, Ibaraki-shi, Osaka 567-8680 (JP)
(72) Inventor: Kiuchi, Kazuyuki, Ibaraki-shi Osaka 567-8680 (JP)
(74) Representative: Grünecker, Kinkeldey, Stockmair & Schwanhäusser

(57) **Abstract**

In a step of performing dicing by sticking a protective tape (2) for protecting a wafer surface, in order to obtain a dicing method which ensures that there is no paste residue on a chip side face and that the protective tape is prevented from peeling from the wafer (1) during the dicing and which is excellent in productivity, in a step of performing dicing by sticking a surface protective adhesive tape having an energy ray-curable adhesive layer on one surface of a substrate, thereby performing surface protection for the surface of the semiconductor wafer where an integrated circuit is to be formed, the energy ray-curable adhesive layer is cured by radiating energy rays (4) beforehand to an inner circumferential portion of the wafer, and dicing is performed, with the energy ray-curable adhesive layer kept in an uncured condition by ensuring that energy rays are not radiated to an outer peripheral portion.

## Description

### BACKGROUND OF THE INVENTION

### Field of the Invention

The present invention relates to a method of dicing a substrate using a surface protective adhesive tape.

### Description of the Related Art

In order to prevent an integrated circuit from being contaminated by cuttings in a wafer dicing step, it has been proposed to stick a surface protective adhesive tape to the surface of a wafer where an integrated circuit is to be formed and to perform dicing in this state (Japanese Patent Laid-Open No. 2003-209073).
However, this method has the drawbacks that the work of peeling a surface protective adhesive tape from a wafer singulated after dicing (hereinafter called a chip) is difficult and that during the peeling an adhesive falls off onto an integrated circuit surface, contaminating the integrated circuit.
There is also known a method in which in order to solve such problems, a surface protective adhesive tape having an energy ray (in particular, ultraviolet ray)-curable adhesive layer is used as an adhesive and peeling is performed after the adhesive layer is cured by performing energy ray radiation during the peeling after dicing (Japanese Patent No. 3045107).
According to this method, peeling becomes more easier than by conventional art and the contamination of the integrated circuit surface is suppressed. However, because dicing is performed, with the energy ray-curable adhesive is kept uncured, the adhesive is torn off by the cutting stress in dicing and the torn-off adhesive sticks to a wafer side face, whereby the side face of the integrated circuit is contaminated. For this reason, a step of removing the contamination is added and this method cannot be put to practical use.
Therefore, when a surface protective adhesive tape having an energy ray (ultraviolet ray)-curable adhesive layer was stuck to a wafer and dicing was performed by curing the adhesive layer, it was possible to prevent the integrated circuit surface and side face from being contaminated by adhesive chips. However, the trouble of falling-off of the surface protective adhesive tape during dicing occurred frequently, posing a new problem that the yield of chips decreases greatly.
It seems that one of the causes of such falling-off of the surface protective adhesive tape is the application of a cutting stress to the tape in a condition in which the adhesive force decreases due to energy ray curing.
Therefore, Japanese Patent Laid-Open No. 8-274048 discloses a method by which dicing is performed after the energy ray curing of only scribe lines and then a surface protective adhesive tape is peeled after the curing of all regions. Although this method is excellent in an increase in the yield of chips, it is necessary to align a mask to very fine scribe lines with high accuracy and each time the chip shape and size are changed due to a change in the integrated circuit, the mask must be changed to adapt to newly changed scribe lines. Thus, it was feared that further contrivances are expected for practical use.

The problem to be solved by the present invention is, in a step of performing dicing by sticking a surface protective adhesive tape for protecting a wafer surface, to obtain a dicing method which ensures that there is no paste residue on a chip side face and that the stuck surface protective adhesive tape is prevented from peeling from the wafer during the dicing and which is excellent in yield and productivity.

### SUMMARY OF THE INVENTION

An adhesive tape having an energy ray-curable adhesive layer is stuck as a surface protective adhesive tape in such a manner as to protect the wafer surface and thereafter, the adhesive layer is cured with the exception of an outermost circumferential portion of the wafer (regions where an integrated circuit is not formed) and dicing is performed. Specifically, the following are provided by the present invention.
1. A dicing method which involves, in a step of performing dicing in which the surface of a semiconductor wafer where an integrated circuit is to be formed is protected by sticking a surface protective adhesive tape having an energy ray-curable adhesive layer on one surface of a substrate, radiating energy rays beforehand to an inner circumferential portion of the wafer, thereby curing the energy ray-curable adhesive layer, and performing dicing, with the energy ray-curable adhesive layer on an outer circumferential portion of the wafer kept in an uncured condition.
2. The dicing method described in 1, in which the integrated circuit is a solid state image sensing device.
3. The dicing method described in 1 or 2 above, in which the energy rays are ultraviolet rays.
4. The dicing method described in 1 or 2, in which the energy ray-curable adhesive layer contains an acrylic high molecular compound as a principal component.
5. The dicing method described in 1 or 2, in which an adhesive tape to be used is such that the adhesive force of the surface protective adhesive tape before curing by energy ray radiation is not less than 0.10 N/10 mm.
6. The dicing method described in claim 1 or 2, in which an adhesive tape to be used is such that the adhesive force of the surface protective adhesive tape after curing by energy ray radiation is less than 0.10 N/10 mm.
7. The dicing method described in claim 1 or 2, in which a surface protective adhesive tape which is a laminate film including a heat-shrinkable film and a non-heat-shrinkable film is used for the substrate.

According to the present invention, by simple means for ensuring that energy rays are not radiated to an outer circumferential portion alone of the wafer, it is possible to prevent individual pieces of cut wafer from being contaminated by an adhesive and reducing the yield during dicing, and to prevent the wafer from cracking and the like. For this reason, it becomes possible to carry out a dicing step excellent in productivity without undergoing a complex step.

### BRIEF DESCRIPTION OF THE DRAWINGS

FIG. 1 is a conceptual diagram showing the condition before the start of the dicing step;
FIG. 2 is a conceptual diagram showing the condition during the dicing step;
FIG. 3 is a conceptual diagram showing a wafer after dicing;
FIG. 4 is a diagram showing the condition during energy ray radiation;
FIG. 5 is a top surface view showing a wafer after the dicing step;
FIG. 6 is an enlarged top surface view showing a chip after dicing by the method of the present invention;
FIG. 7 is an enlarged side face view showing a chip after dicing by the method of the present invention;
FIG. 8 is an enlarged top surface view showing a chip after dicing by the method of Comparative Example 1;
FIG. 9 is an enlarged side face view showing a chip after dicing by the method of Comparative Example 2; and
FIG. 10 is an enlarged side face view showing a chip after dicing by the method of Comparative Example 3.

### DETAILED DESCRIPTION OF THE PREFERRED EMBODIMENTS

In a method of performing dicing using a surface protective adhesive tape having an energy ray-curable adhesive, in view of the above-described background art, the present inventors carried out a close observation of the condition during dicing in order to ensure that dicing with a surface protective adhesive tape can be positively carried out more simply than by conventional art.
As a result, it became apparent that the peeling of a surface protective adhesive tape cured with energy rays, which might cause falling-off, occurs in an outer peripheral portion of the wafer of the first pass in the dicing step and that this falling-off is remarkable in a dicing finish position of the dicing blade. It became also apparent that the water sprayed to the interface between the wafer and the surface protective adhesive tape penetrates into a peeling area.
Wafer edge portions have a shape provided with a region whose edge is removed by beveling (hereinafter referred to a bevel) in order to prevent the edge portions from getting chipped during transfer, positioning and the like. For this reason, when the adhesive layer of the surface protective adhesive tape is cured by energy rays, the surface protective adhesive tape and the wafer in the bevel portion are not in a close contact condition or are merely bonded together with an exceedingly weak adhesive force at most. That is, it seems that when a cutting stress is applied to the tape whose adhesive force is reduced by energy ray curing, in the bevel portion, the surface protective adhesive tape peels readily from the wafer (or lifting occurs and water and the like penetrate into the gap).

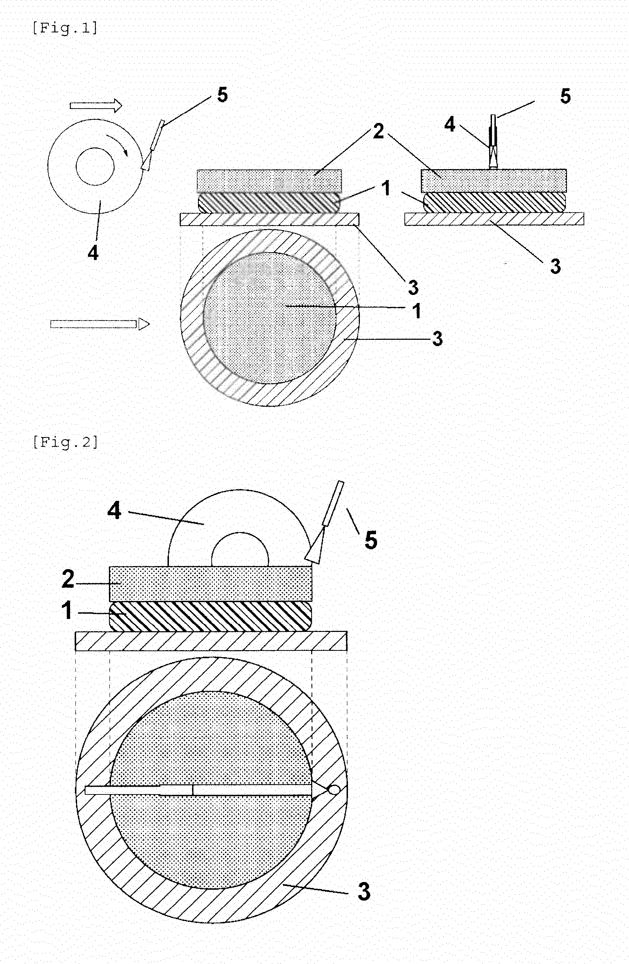

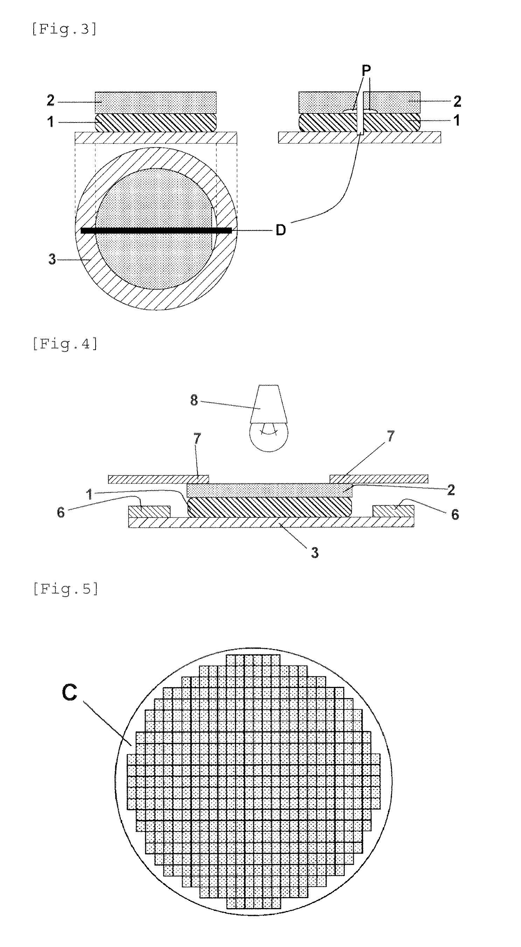

As shown in the conceptual diagram of FIG. 1 showing the condition before the start of the dicing step, in the course of the dicing step, a surface protective adhesive tape 2 is stuck onto a wafer 1 and the wafer 1 is fixed onto a dicing tape 3. In this condition, cutting is performed using a dicing blade 4.
At this time, dicing blade cooling water injected from an injection nozzle 5 to cool the frictional heat generated by cutting, cleaning water to wash away cuttings adhering to the wafer (surface protective adhesive tape) surface, or water which also serves as these kinds of water is constantly sprayed to the wafer surface, and a water spout port is provided in such a manner that the water can be sprayed from a diagonal front position prior to the forward movement of the dicing blade.
As shown in the conceptual diagram of FIG. 2 showing the dicing step, when the dicing blade 4 which has moved while cutting the wafer in the last stage of the first pass, in particular, reaches the outer peripheral portion of the wafer 1, the injection nozzle 5 of the cooling water and cleaning water which has moved at the same time injects the water from the direction in which the water is caused to penetrate into the interface between the bevel and the surface protective adhesive tape 2. This results in giving a shearing force to the surface protective adhesive tape 2 and in the conceptual diagram of FIG. 3 showing a wafer after dicing, there is a possibility that this peels the surface protective adhesive tape 2 as shown by a peeling area P which appears adjacent to a cut area D.
From the above-described points and from the result of the observation of the first pass, it seems that tape peeling occurs remarkably in the outer peripheral portion of the wafer and in the dicing finish position. As a result, the water which has penetrated and cuttings of the surface protective adhesive tape and the wafer adhere to the surfaces of chips obtained by dicing the wafer, leading to defective parts.

Furthermore, because cutting continues also thereafter, the peeling of the outer peripheral portion spreads due to stress and water spraying, with the result that eventually the surface protective adhesive tape peels also from the portion where an integrated circuit is to be formed (the inner circumferential portion of the wafer) and to be protected in dicing.
From the above-described observation and consideration, the present inventors could assume that if the occurrence of peeling by a cutting stress is prevented only in the outer peripheral portion, it is possible to prevent water, wafer beveling chips and adhesive tape cuttings from penetrating into the interface between the surface protective adhesive tape after energy ray curing and the wafer.
Therefore, after the sticking of the energy ray-curable surface protective adhesive tape to the wafer, the region in which an integrated circuit is formed was cured by energy ray radiation, whereas it was ensured that energy rays were not radiated to the adhesive layer corresponding to the outer peripheral portion of the wafer. Dicing was performed in such a manner that although the adhesive force of the adhesive tape in the region where the integrated circuit is formed was reduced, the adhesive force of the surface protective adhesive tape of the outer peripheral portion was not reduced. As a result, it became apparent that dicing can be performed without the falling-off of the surface protective adhesive tape and with the pollution of both of the front surface and side face of an integrated circuit by the adherence of adhesive chips and the cutting water prevented.
On the basis of such items, for a dicing method which is carried out while protecting an integrated circuit using an adhesive tape, the present inventors found out a very useful and simple method.

The method of the present invention will be described below.

### (Outer peripheral portion and inner peripheral portion of wafer)

The outer peripheral portion of the wafer in the present invention is a region from the region in which a circuit is formed in the wafer to the outer circumference of the wafer on the outer side, and in the case where a bevel portion is present on the outer circumference, the outer peripheral portion of the wafer refers to all or part of the region including the bevel portion. The inner circumferential portion of the wafer refers to the region except this outer peripheral portion of the wafer.

### (Dicing method)

The dicing method adopted in the dicing method of the present invention is not limited so long as the adopted dicing method is a publicly-known method. For this reason, the adopted dicing method can be applied to various kinds of dicing methods, such as a half cut, a full cut, and a single cut, furthermore, a step cut, and a bevel cut in a full cut.
Moreover, for the movement of the wafer relative to the blade, it is possible to adopt any method, such as a circular cut and a rectangular cut.
Usually, dicing is performed after back grinding. However, also in the case where dicing is performed first, it is possible to adopt the surface protective adhesive tape of the present invention.
For dicing, it is also possible to adopt a method by which dicing is performed, with the wafer fixed to the adhesive layer surface of a dicing tape. As a result of this, it is possible to prevent the scattering and dispersion of cut chips after the dicing of the present invention is performed.

### (Wafer)

For the wafer for which the dicing method of the present invention is adopted, the wafer size may be any size, and also for materials for the wafer, publicly-known materials, such as silicon, GaAs and InP are used. A wafer having a bevel in the outer peripheral portion thereof can also be used. However, it is not essential that a wafer have a bevel. It is not always necessary that a wafer have a bevel. Because the peeling of a surface protective adhesive tape tends to occur in a wafer having a bevel, it is possible to reduce the possibility of breaking a wafer having a bevel during the handling thereof compared to a wafer having no bevel and it is possible to perform dicing in a stable manner. For this reason, it is preferred that a wafer having a bevel be adopted in the method of the present invention.
As described above, the wafer in the present invention may be such that a dicing tape is stuck to the back surface side thereof. A publicly-known dicing tape can be used as the dicing tape.

### (Surface protective adhesive tape)

The surface protective adhesive tape of the present invention is such that an adhesive layer is formed on one surface of a base material, and the base material may be a shrinkable film which shrinks by heat and the like and is obtained by stretching or biaxially orienting a publicly-known single-layer or multilayer resin film, a non-shrinkable film which is a non-stretched film or a laminated film including a shrinkable film and a non-shrinkable film. However, even when any base material is used, the adhesive layer is cured by the radiation of energy rays such as ultraviolet rays and electron rays and, therefore, it is necessary that the adhesive layer have the property of allowing these energy rays to penetrate therethrough sufficiently. The shrinkable film is a film having the property of shrinking by the stimuli of heat and the like.
Examples of the above-described shrinkable film and non-shrinkable film include stretched films or biaxially oriented films or non-stretched films made of one or more kinds of resins selected from the group consisting of polyesters, such as polyethylene terephthalate, polyolefins, such as polyethylene and polypropylene, polynorbornene, polyimide, polyamide, polyurethane, polystyrene, poly(vinylidene chloride), poly(vinyl chloride) and the like. Among others, because of the excellent coating workability of an adhesive layer, polyester-based resins, polyolefins, such as polyethylene and polypropylene, polynorbornene, and polyurethane-based resins are preferable, and furthermore, in consideration of the workability expected when a surface protective adhesive tape is peeled after dicing, stretched films or biaxially oriented films which are shrinkable films are preferable.

In the case where at least one shrinkable film is adopted in the base material of a surface protective adhesive tape, it is preferred that the shrinkable film have shrinkage factors of 3 to 90% in the temperature range of 40 to 180°C. The shrinkage factor is more preferably 5 to 90%, still more preferably 10 to 90%, and most preferably 20 to 90%. If the shrinkage factor is less than 3%, the amount of shrinkage of a shrinkable film is insufficient. Therefore, edge portions of a chip cannot be exfoliated and pickup is impossible. In the case where the shrinkage factor is larger than 90%, the amount of shrinkage is too large and there is a possibility that a chip is broken.

Preferably, the base material of the surface protective adhesive tape is such that at least a shrinkable film layer having the property of shrinking in the uniaxial direction, a constraining layer including a non-shrinkable film constraining the shrinkage of the shrinkable film layer, and an adhesive layer are laminated in this order, and when a stimulus, such as heat, which causes shrinkage, is given, the base material spontaneously warps in one direction from one end portion or to the center from opposed two end portions, with the result that the surface protective adhesive tape and the edge portions of a chip can be peeled from each other.

The above-described constraining layer including a non-shrinkable film may also be composed of an elastic layer having the adhesive properties on the shrinkable film side and a non-shrinkable rigid film layer on the side opposite to the shrinkable film layer. And the surface protective adhesive tape of the present invention has an adhesive layer and this adhesive layer includes an active energy ray-curable adhesive, active energy rays being infrared rays and the like. Also in this case, it is necessary to provide sufficient energy ray penetrability, including that of both of the shrinkable film and the constraining layer.

Preferably, as laminates of a shrinkable film layer/a constraining layer, it is possible to use laminates of a shrinkable film layer/an elastic layer/a rigid film layer which is a non-shrinkable film/an adhesive layer(hereinafter, these laminates are sometimes called a spontaneously rolling tape). Because of this constitution, a contraction stress is converted to a torque and the tape is positively deformed into a cylindrical rolling-up body which gives a stimulus providing the cause of contraction.
Details of materials constituting the tape and the like may be those described in Japanese Patent No. 4151850. Specifically, it is preferred that the tape be a spontaneously rolling tape as a laminate composed of a shrinkable film layer/an elastic layer/a rigid layer/an adhesive layer. And preferably, a stimulus for causing shrinkage is heating.

It is preferred that the surface protective adhesive tape have an adhesive force in a 23°C atmosphere obtained when the energy ray-curable adhesive layer is before curing (in an uncured condition) (silicon mirror wafer tension speed 300 mm/min in 180° peeling) which is not less than 0.10 N/10 mm. The adhesive force is more preferably not less than 0.15 N/10 mm, still more preferably not less than 0.2 N/10 mm, and most preferably not less than 1.0 N/10 mm.
If the adhesive force is not less than 0.10 N/10 mm, the surface protective adhesive tape has a sufficient adhesive force against the wafer before energy ray radiation and the surface protective adhesive tape does not shift. The surface protective adhesive tape does not peel along the external circumference of the wafer, either.
The adhesive force in a 23°C atmosphere obtained when the energy ray-curable adhesive layer is in a cured condition (silicon mirror wafer tension speed 300 mm/min in 180° peeling) is less than 0.1 N/10 mm, preferably not more than 0.07 N/10 mm, and more preferably not more than 0.05 N/10 mm.
If the adhesive force is less than 0.1 N/10 mm, it is possible to smoothly peel the surface protective adhesive tape from the chip after dicing and the chip will not be broken.

The thickness of the adhesive layer is usually 1 to 200 µm, preferably 5 to 100 µm, and more preferably 10 to 75 µm. If the above-described thickness is too small, the adhesive force is insufficient and, therefore, it becomes difficult to hold and temporarily fix an adherend. If the above-described thickness is too large, this is uneconomical and the adhesive layer is not easy to handle. Furthermore, a decrease in the cutting workability due to the clogging of the blade is feared and hence too large a thickness is undesirable.

In the range in which the adhesive properties as described above are provided, in the case where the base material of the surface protective tape is a shrinkable film, it is necessary that shrinkage occur by a stimulus.
A stimulus refers to treatment by energy giving means, such as heating, necessary for shrinking the surface protective adhesive tape which is stuck. Specifically, it is possible to use heating means, such as injection of heated air, immersion into a liquid, such as heated water, an infrared lamp, an infrared laser, an infrared LED, a plate heater, a hand heater, and a ribbon heater.
The heating temperature is a temperature having no adverse effect on the properties of the wafer. The heating temperature is not less than 40°C, preferably 50°C to 180°C, and more preferably 70 to 180°C. Treatment is performed to such an extent that a heat-shrinkable film layer, in particular, of a surface protective adhesive tape is shrunk by such heating, whereby this surface protective adhesive tape is caused to warp in such a manner as to peel from a chip obtained by dicing. In the case where the above-described means by immersion into heated water is adopted, it may sometimes be necessary to adopt a step in which publicly-known drying means for drying after the immersion is used.

By adjusting an adhesive force between the surface protective adhesive tape and the wafer, it is ensured that the surface protective adhesive tape does not completely peel from the chip even by the shrinkage of the surface protective adhesive tape under the influence of a stimulus and that end portions of the surface protective adhesive tape are peeled from the chip. For this reason, it is necessary that the chip be stuck to the surface protective adhesive tape with such a strength that might allow the peeling of the edge portions.

As these surface protective adhesive tapes, preferably, at least a shrinkable film layer having the property of shrinking in the uniaxial direction and a constraining layer constraining the shrinkage of the shrinkable film layer are laminated. When a stimulus which causes shrinkage is given, the surface protective adhesive tape, as used singly, spontaneously rolls from two opposed end portions toward the center forms one cylindrical rolling body.

In some cases, it is necessary to reduce the adhesive force of the surface protective adhesive tape relative to the chip after the pickup of the chip.
As an adhesive layer of such a surface protective adhesive tape, it is possible to adopt an adhesive tape composed of a publicly-known adhesive.
For example, it is possible to use a publicly-known adhesive which is such that the adhesive force decreases as a result of curing by the formation of a three-dimensional network by the radiation of active energy rays, such as ultraviolet rays, and peeling becomes easy, a gas generating agent containing adhesive which is such that stimuli (further energy ray radiation and heat) are given to a gas generating agent contained in an adhesive agent layer, such as an azide and an azo compound, whereby a gas is generated by decomposition, the adhesive area is reduced by causing the gas to migrate to the surface of the adhesive, and the property of peeling easily is caused to manifest itself, or a heat expansible microsphere containing adhesive which is such that heat expansible microsphere contained in the adhesive are caused to expand by heating and the adhesive surface is deformed to provide asperities, whereby the adhesive area is reduced and the property of exfoliating easily is caused to manifest itself.

Although as an adhesive layer provided in such a surface protective adhesive tape, it is possible to use adhesives obtained by adding fillers and various kinds of publicly-known additives to publicly-known rubber-based resins, acrylic resins, acrylic saturated polyester resins, thermoplastic polyurethane-based resins, amid-based resins, imide-based resins, silicone-based resins and the like, publicly-known adhesives are used which are such that the adhesive force decreases as a result of curing by the formation of a three-dimensional network by the radiation of active energy rays, such as ultraviolet rays, and peeling becomes easy.
In adhesive compositions obtained by blending publicly-known various kinds of additives with such resins, it is possible to use adhesive compositions which are such that resins constituting the compositions are chemically modified by carbon-carbon multiple bond containing reactive groups, and adhesive compositions which are such that monomers and polymers having reactive groups, such as (methacryloyl) groups, are blended.
For example, acrylic resins may contain units corresponding to other monomer components capable of copolymerization with (methacrylic) acrylic alkylester or cycloalkylester as required for the purpose of modification of cohesive force and heat resistance. Examples of such monomer components include carboxyl group containing monomers, such as acrylic acid, methacrylic acid, carboxyethyl (methacrylate) acrylate, carboxypentyl (methacrylate)acrylate, itaconic acid, maleic acid, fumaric acid, and crotonic acid; acid anhydride monomers, such as maleic anhydride and itaconic acid anhydride; hydroxyl group containing monomers, such as (methacrylic) acrylic acid 2-hydroxyethyl and (methacrylic) acrylic acid 2-hydroxypropyl; sulfonic acid group containing monomers, such as styrene sulfonic acid; phosphoric acid group containing monomers, such as 2-hydroxyethyl acryloyl phosphate; acrylamide, acrylonitrile and the like. One kind or two or more kinds of these monomers capable of copolymerization can be used. It is preferred that the used amount of these monomers capable of copolymerization be not more than 40% by weight of all monomer components.

Apart from the above-described adhesives, for crosslinking purposes the above-described acrylic resins can contain polyfunctional monomers and the like when required as monomer components for copolymerization. Examples of such polyfunctional monomers include hexanediol diacrylate (methacrylate) and (poly)ethylene glycol diacrylate (methacrylate). Also one kind or two or more kinds of these polyfunctional monomers can be used. From the standpoint of the adhesive properties and the like, it is preferred that the used amount of polyfunctional monomers be not more than 30% by weight of all monomer components. It is also possible to add polyisocyanate compounds, epoxy compounds, aziridine compounds, and external crosslinking agents, such as melamine-based crosslinking agents.

For energy ray-curable adhesives as adhesives, those having the above-described energy ray-curable functional groups of carbon-carbon bond and the like and having adhesive properties can be used without limitation, and for example, in addition to the above-described acrylic adhesives, it is possible to adopt addition-type energy ray-curable adhesives which are obtained by blending energy ray-curable monomer components and oligomer components with the above-described general adhesives such as rubber-based adhesives.

Examples of energy ray-curable monomer components to be blended include urethane oligomer, urethane acrylate (methacrylate), and trimethylolpropanetri (methacrylate) acrylate. And examples of energy ray-curable oligomer components include various kinds of oligomers, such as urethane-based, polyether-based, polyester-based, polycarbonate-based, and polybutadiene-based oligomers, and energy ray-curable oligomer components whose molecular weight is in the range of the order of 100 to 30000 are appropriate. Blended amounts of energy ray-curable monomer components and oligomer components can be determined appropriately according to the kinds of the above-described adhesive layers as amounts capable of reducing the adhesive force of adhesive layers. In general, these amounts are, for example, 5 to 500 parts by weight, preferably on the order of 40 to 150 parts by weight relative to 100 parts by weight of base polymer in acrylic polymers constituting an adhesive.

Besides the addition-type energy ray-curable adhesives described above, it is possible to mention intrinsic-type energy ray-curable adhesives in which, as a base polymer, a carbon-carbon double bond is present in a polymer-side chain or a main chain or at ends of a main chain. In intrinsic-type energy ray-curable adhesives, because it is not necessary that oligomer components, which are low-molecular components, and the like be contained, or because contents are not high, oligomer components and the like do not migrate with time in the adhesives and it is possible to form adhesive layers of stable layer structure; this is desirable.

For the above-described base polymer having carbon-carbon double bonds, it is possible to use those having carbon-carbon double bonds and having adhesive properties without limitation. As such base polymers, those having acrylic polymers in basic skeleton are desirable. The acrylic resins whose examples were enumerated above are used as basic skeletons of acrylic resins.

Methods of introducing carbon-carbon double bonds into the above-described acrylic resins are not limited and various methods can be adopted. Introduction of carbon-carbon double bonds into polymer-side chains is easy in terms of molecular design. For example, it is possible to mention a method by which after the copolymerization of a monomer having a functional group with an acrylic resin, a compound having a functional group capable of reacting with this functional group and a carbon-carbon double bond is caused to perform a condensation reaction or an addition reaction, with the energy ray curing properties of the carbon-carbon double bond maintained.

Examples of combinations of these functional groups include a carboxylic acid group and an epoxy group, a carboxylic acid group and an aziridyl group, and a hydroxyl group and an isocyanate group. Among these combinations of functional groups, the combination of a hydroxyl group and an isocyanate group is preferable in terms of the easiness of reaction tracing. In these combinations of functional groups, if the combinations are such that the above-described acrylic polymers having a carbon-earbon double bond are generated, the functional groups can be present on either side of acrylic polymers and the above-described compounds. However, in the above-described desirable combinations, the case where acrylic polymers have a hydroxyl group and the above-described compounds have an isocianate group is preferable. In this case, examples of isocianate compounds having a carbon-carbon double bond include methacryloyl isocianate, 2-methacryloyloxyethyl isocianate, m-isopropenyl-α, and α-dimethylbenzyl isocianate. As acrylic polymers, those in which the hydroxyl group containing monomers whose examples are enumerated above, and ether-based compounds, such as 2-hydroxyethylvynilether, 4-hydroxybutylvinylether, and diethyleneglycolmonovinylether, are copolymerized, are used.

Although for energy ray-curable adhesives, the above-described base polymers having a carbon-carbon double bond (in particular, acrylic polymers) can be used singly, it is also possible to blend the above-described radiation ray-curable monomer components and oligomer components to such an extent that the properties are not worsened thereby. Usually, blended amounts of radiation ray-curable oligomer components and the like are not more than 100 parts by weight relative to 100 parts by weight of base polymers, and preferably in the range of 0 to 50 parts by weight.

In the case where curing is caused to occur by ultraviolet rays and the like, the above-described energy ray-curable adhesives are caused to contain a photopolymerization initiator. Examples of a photopolymerization initiator include ketal-based compounds, such as 4-(2-hydroxyethoxy) phenyl (2-hydroxy-2-propyl) ketone; aromatic sulfonyl chloride-based compounds, such as 2-naphthalenesulfonyl chloride; photoactive oxime-based compounds, such as 1-phenyl-1 and 1-propanedione-2-(o-ethoxycarbonyl) oxime; benzophenon-based compounds, such as benzophenon, benzoylbenzonic acid, and 3-3'-dimethyl-4-methoxy benzophenon; thioxanthone-based compounds, such as thioxanthone and 2-chloro thioxanthone; camphorquinone; kenone halide; acylphosphinoxide; and acylphosphonate. Blended amounts of an optical copolymerization initiator are, for example, on the order of 0.05 to 20 parts by weight relative to 100 parts by weight of base polymer of acrylic polymers and the like constituting adhesives.

Examples of energy ray-curable adhesives include rubber-based adhesives and acrylic adhesives which contain addition polymerization compounds having two or more unsaturated bonds, optical oplimerization compounds, such as alkoxysilane having an epoxy base, and photopolymerization initiators, such as carbonyl compounds, organic sulfur compounds, peroxides, amines, and onium salt-based compounds.

### [Dicing method of the present invention]

Before the method of the present invention is carried out, the step of sticking a surface protective adhesive tape to a wafer is carried out, and as required, the back surface grinding of this wafer is carried out. A dicing tape is stuck to the back surface side of this wafer and thereafter the dicing step of cutting the wafer along with the surface protective adhesive tape of the present invention into chips is carried out.
After the dicing step, the step of picking up chips with the surface protective adhesive tape and moving the chips to prescribed members is carried out, and subsequently it is possible to carry out the step of heating the surface protective adhesive tape, thereby causing contraction stresses to be generated by a stimulus, and peeling the surface protective adhesive tape from edge portions of the chips.
Details in this case will be given below.

### [Step of sticking surface protective adhesive tape]

The adhesive layer surface of the above-described surface protective adhesive tape is caused to be opposed to the surface of the wafer placed on a table where a circuit is to be formed and brought into contact with this surface of the wafer, and this adhesive layer surface is brought into tight contact with the wafer surface and fixed thereto by performing pressing from the back surface side of the surface protective adhesive tape using a pressing roller and the like. Although this pressing step is carried out using a pressing roller, it is also possible to set the surface protective adhesive tape placed on the surface of the wafer where a circuit is to be formed in a vessel capable of pressurization and thereafter to perform sticking by pressurizing the inside of the vessel.
Although usually, this sticking step is carried out before the back grinding step, this step may be carried out after the back grinding step.When this sticking step is carried out before the back grinding step, the surface protective adhesive tape functions also as the back grinding tape.

### [Step of sticking dicing tape]

In the same manner as with the above-described step of sticking the surface protective adhesive tape, the adhesive layer surface of the above-described dicing tape is caused to be opposed to the back surface of the wafer (the unground surface or the ground surface) and brought into contact with this back surface of the wafer, and this adhesive layer surface is brought into tight contact with the wafer back surface and fixed thereto by performing pressing from the back surface side of the dicing tape using a pressing roller and the like or by pressurizing the inside of the pressurizing vessel. Usually, also a dicing ring is stuck in this sticking step.

### [Step of curing adhesive of surface protective adhesive tape]

Before or after the above-described step of sticking the dicing tape, it is necessary to cure the adhesive layer of the surface protective adhesive tape in a portion other than an outer circumferential portion by radiating energy rays to the adhesive layer of this portion other than the outer circumferential portion.
The cured condition in the present invention refers to the condition in which a curing agent and curing components contained in an energy ray-curable adhesive layer react sufficiently and become cured. For this cured condition, the adhesive force after radiation is performed until a radiation level of 150 mJ/cm² is obtained is measured and also the adhesive force before this radiation is measured; this cured condition is considered to have occurred when the adhesive force after radiation is lower than ((adhesive force before radiation - 150 mJ/cm² adhesive force after radiation)/2 + 150 mJ/cm² adhesive force after radiation).
The uncured condition in the present invention involves the condition in which even when the curing agent and curing components have reacted to some extent, the adhesive force does not decrease greatly and almost all curing agent and reactive components remain.
As means for partially curing the surface protective adhesive tape like this, at least the following three can be mentioned:
1. An energy ray non-penetrating mask capable of covering the wafer outer peripheral portion of a surface protective adhesive tape is provided on the surface side of a portion of the base material opposed to this wafer outer circumferential portion and energy rays are radiated from above the mask, whereby the adhesive layer opposed to portions other than the outer peripheral portion is cured, without the curing of the adhesive layer of the surface protective adhesive tape opposed to the mask.
2. In a lamp and the like for radiating energy rays, the range of the rays which are radiated is narrowed so that the energy rays are not radiated to a portion opposed to the outer peripheral portion of the surface protective adhesive tape, with the result that portions other than the portion to which the energy rays are not radiated are cured, without the curing of the portion to which the energy rays are not radiated.
3. It is ensured that the base material of a portion of the surface protective adhesive tape corresponding to the outer peripheral portion of the wafer does not allow energy rays to penetrate. For example, the base material of this portion is coated with an energy ray non-penetrating ink.
FIG. 4 is a diagram showing the condition during the energy ray radiation performed using the means described in 1 above. A wafer 1 is supported on a dicing table 3 and a surface protective adhesive tape 2 is stuck to the surface of the wafer 1. The dicing table 3 is fixed by a dicing ring 6, and a mask 7 is provided in such a manner as to cover the surface protective adhesive tape 2, the outer peripheral portion of the wafer 1, and a place corresponding to the dicing ring 6.
In this condition, ultraviolet rays are radiated from above by a ultraviolet ray light source 8, which is an energy ray source opposed to the wafer 1, whereby the adhesive layer of the surface protective adhesive tape 2 covered with the mask 7 is not cured, but the adhesive layer of the surface protective adhesive tape 2 of other portion is cured.
FIG. 5 is a front view showing the wafer 1, with the surface protective adhesive tape 2 stuck, the mask 7 being removed after the dicing step. In the inner circumferential portion of the wafer, there are circuits which were formed, and no circuit is formed outside the region where the circuits were formed. In FIG. 5, the portion of the surface protective adhesive tape 2 where the adhesive layer is not cured is in the region C where no circuit is formed.

### [Dicing step]

In the present invention, dicing is performed after this surface protective adhesive tape is stuck to an adherend. As the dicing method, various blade dicing methods can be selected arbitrarily in addition to the above-described dicing method. It is also possible to adopt a step in which water and gas injection is used in combination in cut portions during dicing, and there is no limitation due to the use of the surface protective adhesive tape.
In the case where an adherend is a semiconductor wafer, it is also possible to adopt a method by which the back grind step is performed after the surface protective adhesive tape is stuck to the adherend and the dicing step is performed after sticking the dicing tape, without removal of the surface protective adhesive tape.

### [Pickup step]

The method and device used in the pickup step are not limited. It is possible to adopt a publicly-known technique which involves picking up a needle of any diameter and shape from the dicing tape side of a chip, thereby peeling the chip and picking up the chip using a pickup device. In some cases, an expanding step by an expanding device may be carried out before the pickup step.

### [Step of peeling wafer edge portions]

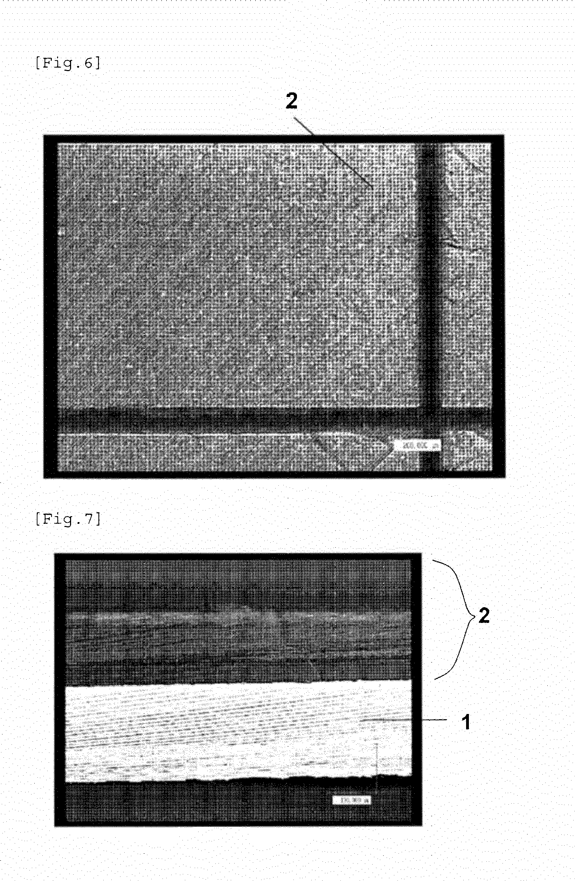

In the case where the surface protective adhesive tape is not a spontaneously rolling tape, the surface protective adhesive tape whose adhesive force has been reduced by radiating energy rays is peeled and removed by publicly-known means.
In the case where the surface protective adhesive tape is a spontaneously rolling tape, after dicing, the cut surface protective adhesive tape shrinks by being stimulated to generate a force with which the surface protective adhesive tape tends to roll up. In particular, in the edge portions of the chip, this force with which the surface protective adhesive tape tends to roll up generates a force with which the edge portions of the surface protective adhesive tape tend to warp upward, and peeling proceeds smoothly in such a manner as to form a cylindrical rolling-up body.
Because in the use of both of the surface protective adhesive tapes, the adhesive layer of the surface protective adhesive tape is cut in a cured condition, protruding of the adhesive which might cover the chip does not occur as shown in FIG. 7. Thus, phenomena which might impede the peeling work do not occur.

Among various stimuli, a stimulus by heat can be obtained by adopting publicly-known heating methods by a hot plate, a heater, a heat gun, an infrared lamp and the like as a heating source.
An appropriate method is selected and used so that temperatures at which the deformation of the surface protective adhesive tape occurs rapidly are obtained. Heating temperatures are not limited so long as a wafer rolls up without being affected by upper limit temperatures. Heating temperatures are, for example, not less than 40°C, preferably 50°C to 180°C, and more preferably 70°C to 180°C. A stimulus which causes shrinkage is uniformly given and all surface protective adhesive tapes are deformed at a time. Furthermore, a stimulus may be given to part of the wafer in a spot-like manner. For example, it is possible to adopt a method by which the wafer is partially heated in any position using a spot heating device and the like.

### [Embodiment]

### (Example of production of adhesive)

### (Adhesive 1)

An acrylic polymer (weight-average molecular weight: 700,000) was obtained by copolymerization from a toluene solution obtained by adding 0.2 part by weight of a polymerization initiator benzyl peroxide to 100 parts by weight of a mixture of butyl acrilate: ethyl acrilate: 2-hydroxy ethyl acrilate = 50 : 50 : 20 (molar ratio).
Eighty molar percent of 2-isocyanatoethylmethacrylate (made by Showa Denko K.K., trade name: Karenz MOI) was blended with a hydroxyl group derived from 2-hydroxy ethyl acrilate of the above-described acrylic polymer, 0.03 part by weight of addition reaction catalyst dibutyltin dilaurylate was blended with 100 parts by weight of the above-described acrylic polymer, and the mixture was caused to react at 50°C for 24 hours in an air atmosphere, whereby an acrylic polymer having a methacrylate base on a side chain was prepared.
An adhesive 1 was obtained by adding 3 parts by weight of radical-based photopolymerization initiator (made by BASF, trade name: "IRGACURE 651"), and 0.2 part by weight of isocyanate compound (made by Nippon Polyurethane Industry, Co., Ltd., trade name: CORONATE L) to 100 parts by weight of the obtained acrylic polymer having a methacrylate base on a side chain.

### (Example of production of the base material of surface protective adhesive tape)

### (Base material 1)

A polyethylene terephthalate (PET) film (made by Toray Industries, Inc., one side subjected to corona treatment, Lumirror-S105 (thickness 38 µm)) was used as a rigid film.
NB300 (made by Dainichiseika Color & Chemicals Mfg. Co., Ltd., containing a pale blue pigment) was applied to the corona treated side of this rigid film layer using a gravure coater so that the film thickness after drying became 1 to 2 µm and then dried, whereby a rigid film with an organic coating layer was obtained.
Using an adhesive, the corona treated surface of a heat shrinkable polyester film (made by TOYOBO CO., LTD., Spaceclean S7200, film thickness 30 µm, one side subjected to corona treatment) was stuck to opposite surface of the organic coating layer of the above-described rigid film layer by the dry laminate method, whereby a base material 1 was fabricated.
The adhesive used in the dry laminate was obtained by mixing Takerack A520 and Takenato A10, made by Mitsui Chemicals Inc., and ethyl acetate at a weight ratio of 6 : 1 : 5.5. The thickness of the adhesive after drying was 2 to 4 µm.

### (Example of production of surface protective adhesive tape)

### (Surface protective adhesive tape 1)

Using a die coater, the adhesive 1 obtained in the example of production of the adhesive was applied to the release-treated surface of one-side silicone release-treatment PET separator (made by TORAY ADVANCED FILM CO., LTD., trade name "Cellapeel MD(A)(R)") so that the dry film thickness became 50 µm, and thereafter stuck to the organic coating layer side of the base material 1 obtained in the example of production, whereby the surface protective adhesive tape 1 was obtained.

### [Dicing]

### (Method of fabricating dicing samples)

The surface protective adhesive tape 1 obtained in the example of production was applied to a mirror surface of an 8-inch silicon mirror wafer using a 2-kgf hand roller.
Next, back surface grinding was performed using a back grinder (made by DISCO Corporation, DFG8560) so that the silicon mirror wafer thickness became 200 µm.
In Embodiment 1, ultraviolet ray radiation was performed by placing an ultraviolet ray blocking material, which will be described later, on the surface protective adhesive tape layer side of a dicing sample (see the schematic view of FIG. 1), whereby only a portion of the adhesive layer of the surface protective adhesive tape 1 corresponding to the wafer outer circumferential portion was brought to an uncured condition. Ultraviolet ray radiation was carried out using "UM810" made by NITTO SEIKI CO., Ltd. so that the accumulated amount of light became 150 mJ/cm². As the ultraviolet ray blocking material, a polyimide film (made by DU PONT-TORAY Co., LTD., trade name "Kapton 200H") was cut to a size capable of covering the whole radiation surface and then a hole was cut on the inner side of the film to produce a circle having a diameter of 190 mm within the radiation surface. The film was capable of blocking light along an outer circumference of 5 mm of an 8-inch wafer.
In Comparative Examples 1 and 2, the adhesive layer of the surface protective adhesive tape 1 was cured without using the ultraviolet ray blocking material. In Comparative Example 3, ultraviolet ray radiation was not carried out.
For the samples after ultraviolet ray radiation, as shown in the schematic view of FIG. 2, dicing was performed after the installation of the dicing ring and the dicing tape (made by NITTO DENKO CORPORATION, trade name "UE-2187G").

### (Dicing method and conditions)

In dicing, wafers were cut to a chip size of 7.5 mm x 7.5 mm using "DFD-6450" made by DISCO Corporation. Detailed conditions are shown in Table 1 below. For the cutting methods of Table 2 showing the results of Embodiment and Comparative Examples, the case of a single cut shows that dicing was carried out using only the Z2 blade and the case of a step cut shows that dicing was carried out using the Z1 blade first and then the Z2 blade.

**[Table 1]**

| Item | | Unit | Setting |
|---|---|---|---|
| Blade rotation | | | Down cut |
| Feed speed | | mm/sec. | 40 |
| Water pressure | Blade | L/min. | 2 |
| | Shower | L/min. | 1 |
| | Spray | L/min. | 1 |
| Index | CH1 | mm | 7.5 |
| | CH2 | mm | 7.5 |
| Z1 blade | Part number | | Made by DISCO Corporation NBC ZH2050HEEE |
| | Rotation number of spindle | rpm | 30000 |
| | Blade height | µm | 300 |
| Z2 blade | Part number | | Made by DISCO Corporation NBC ZH2050SEHECC |
| | Rotation number of spindle | rpm | 30000 |
| | Blade height | µm | 60 |

### [Measurement of adhesive force before and after ultraviolet ray curing]

A surface protective adhesive tape obtained in the example of production was cut to a size of 120 mm length × 10 mm width and stuck to the mirror surface of a silicon wafer using a 2-kgf hand roller.
Next, the sample was fixed to the sample fixing bed of a peel peeling testing machine and after that, the sample was joined using a joining adhesive tape so that the angle formed between the surface protective adhesive tape and the tension jig became 180°.
The sample was stretched in an atmosphere at a room temperature (23°C) at a tensile rate of 300 mm/min. so that the tension jig became parallel to the length direction, and a force (N/10 mm) obtained when peeling occurred between the surface protective adhesive tape and the silicon wafer was measured.
After the surface protective adhesive tape stuck to the mirror surface of the silicon wafer, ultraviolet ray radiation was performed from the side of the base material of the surface protective adhesive tape (using "UM810" made by NITTO SEIKI CO., Ltd. so that the accumulated amount of light became 150 mJ/cm²). After that, the adhesive force after curing was measured.

### [Peeling of surface protective adhesive tape after dicing]

Dicing lines after dicing were observed under a laser microscope (made by KEYENCE CORPORATION, VK8510, 100 to 500 times) and the dicing lines were rated as follows using a range finder attached to the microscope; that is, when the surface protective adhesive tape fell off from the wafer surface or when peeling of not less than 100 µm occurs even in one place from a dicing cutting line (a scribe line) even when the surface protective adhesive tape remained on the wafer, these cases were marked with × and other cases where these phenomena did not occur were marked with ○.

### [Chip paste residue]

Silicon chips with surface protective adhesive tape after dicing were recovered, chip side faces were observed under a laser microscope (made by KEYENCE CORPORATION, VK8510, 100 to 500 times), and the condition of samples was evaluated based on whether there is an adhering substance derived from the adhesive. A closer observation was carried out using a range finder attached to the microscope. If there is even one part of not less than 10 µm in any place of an adhering substance, this case was marked with × and other cases were marked with ○.

**[Table 2]**

| | Surface protective adhesive tape | Base material | Adhesive layer | Adhesive force before ultraviolet ray curing (N/10 mm) | Adhesive force after ultraviolet ray curing (N/10 mm) | Condition for ultraviolet ray curing before dicing | Cutting method | whether or not peeling of adhesive tape occurred after dicing | Chip paste residue |
|---|---|---|---|---|---|---|---|---|---|
| Embodiment 1 | Surface protective adhesive tape 1 | Base material 1 | Adhesive 1 | 6.55 | 0.03 | Uncured in the area 5 mm inside from outermost circumference | Step | O | O |
| Comparative Example 1 | Surface protective adhesive tape 1 | Base material 1 | Adhesive 1 | 6.55 | 0.03 | Whole area, cured | Step | × | - |
| Comparative Example 2 | Surface protective adhesive tape 1 | Base material 1 | Adhesive 1 | 6.55 | 0.03 | Whole area, cured | Single | × | - |
| Comparative Example 3 | Surface protective adhesive tape 1 | Base material 1 | Adhesive 1 | 6.55 | 0.03 | Whole area, uncured | Step | O | × (Chip side face) |

In Embodiment 1, the area 5 mm inside from the outermost circumference, including the bevel portion of the wafer, was made uncured and, therefore, during dicing the surface protective adhesive tape did not peel in the bevel portion. As shown in the enlarged top surface view of FIG. 6 showing a chip after dicing, also the diced chip surface is covered with a surface protective adhesive tape without peeling, and no small piece of adhesive adheres to the surface of the chip. Furthermore, as shown in the enlarged side face view of FIG. 7 showing a chip after dicing, no piece of adhesive and the like adheres to the side face of the chip obtained by dicing.

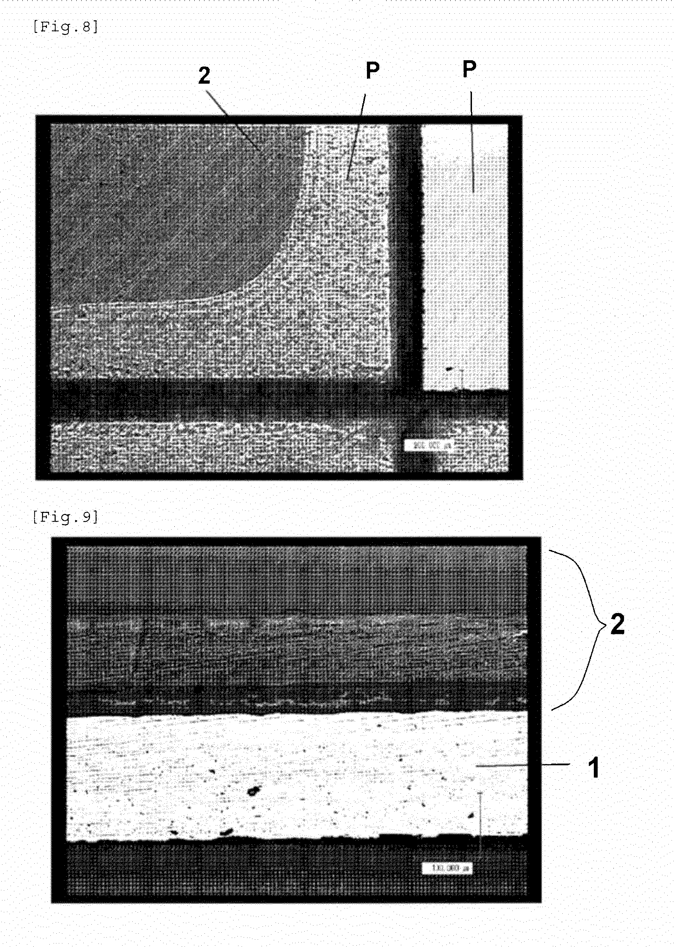

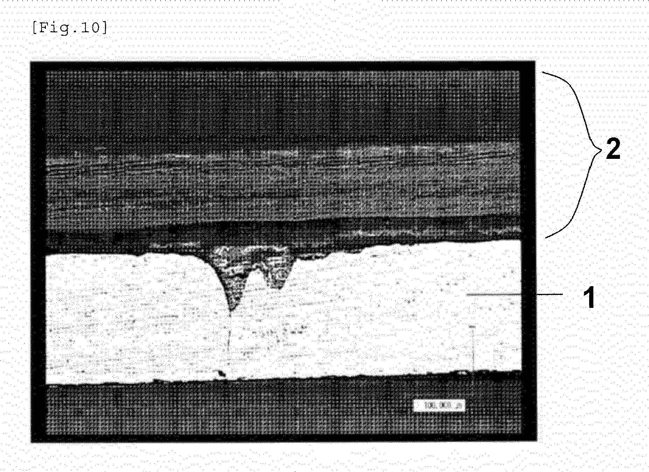

Although in Comparative Examples 1 and 2 the same surface protective adhesive tape as the surface protective adhesive tape used in Embodiment 1 was used, ultraviolet rays were radiated to the whole area of the surface protective adhesive tape stuck before dicing, and a step cut or a single cut was adopted as the cutting method.
In Comparative Examples 1 and 2, no paste residue occurred in the chips. However, as the results of Comparative Example 1 of FIG. 8 reveal, in the surface protective adhesive tape after dicing, peeling P occurred between the adhesive tape and the wafer. The peeling occurred between the chip and the surface protective adhesive tape due to the water and the like used during dicing.
Although the same surface protective adhesive tape as in Embodiment 1 was used in Comparative Example 3, ultraviolet ray curing was not performed during dicing. Therefore, the adhesive layer of the surface protective adhesive tape was uncured. In this example, peeling did not occur between the adhesive tape and the wafer after dicing. However, as shown in FIGS. 9 and 10, the adhesive A adhered to the chip side face and it is apparent that a paste residue occurred.
According to the above-described results of the embodiment and comparative examples, in the present invention, the adhesive layer of the surface protective adhesive tape in the outer circumferential portion of the wafer is uncured and the adhesive layer of the surface protective adhesive tape in the inner circumferential portion of the wafer is cured by energy rays, such as ultraviolet rays, whereby the peeling of the surface protective adhesive tape and contamination of chips by the dicing step are prevented, with the result that it is possible to produce the effect that chips free from contamination can be produced in a stable manner.

1 ... Wafer
2 ... Surface protective adhesive tape
3 ... Dicing tape
4 ... Dicing blade
5 ... Nozzle
6 ... Dicing ring
7 ... Mask
8 ... Light source of ultraviolet rays
P ... Peeling area
A ... Adhesive
C ... Region where no circuit is formed
D ... Cut area

## Claims

1. A dicing method which is used in a step of performing dicing by sticking a surface protective adhesive tape having an energy ray-curable adhesive layer on one surface of a substrate, thereby performing surface protection for the surface of a semiconductor wafer where an integrated circuit is to be formed, comprising:
curing the energy ray-curable adhesive layer by radiating energy rays beforehand to an inner circumferential portion of the wafer; and
performing dicing, with the energy curable-adhesive layer of an outer peripheral portion of the wafer kept in an uncured condition.

2. The dicing method according to claim 1, wherein the integrated circuit is a solid state image sensing device.

3. The dicing method according to claim 1 or 2, wherein the energy rays are ultraviolet rays.

4. The dicing method according to claim 1 or 2, wherein the energy ray-curable adhesive layer contains an acrylic high molecular compound as a principal component.

5. The dicing method according to claim 1 or 2, wherein an adhesive tape to be used is such that the adhesive force of the surface protective adhesive tape before curing by energy ray radiation is not less than 0.10 N/10 mm.

6. The dicing method according to claim 1 or 2, wherein an adhesive tape to be used is such that the adhesive force of the surface protective adhesive tape after curing by energy ray radiation is less than 0.10 N/10 mm.

7. The dicing method according to claim 1 or 2, wherein a surface protective adhesive tape which is a laminate film including a heat-shrinkable film and a non-heat-shrinkable film is used for the substrate.
